# FASCICULE DE BREVET EUROPEEN

(11) **EP 0 844 812 B1**
(45) Date de publication et mention de la délivrance du brevet: **27.12.2000**
(21) Numéro de dépôt: 97402741.9
(22) Date de dépôt: 17.11.1997
(51) Int. Cl.: H05K 7/20

(54) **Dispositif de refroidissement pour composants IGBT**
Kühlungsvorrichtung für IGBT-Transistoren
Cooling device for IGBT devices

(30) Priorité: 21.11.1996 FR 9614209
(43) Date de publication de la demande: 27.05.1998
(73) Titulaire: GEC ALSTHOM TRANSPORT SA, 75116 Paris (FR)
(72) Inventeur: Dubelloy, Jean-Luc, 65000 Tarbes (FR)
(74) Mandataire: Gosse, Michel

(56) Documents cités:
- DE-A- 3 908 996
- US-A- 3 481 393
- US-A- 3 917 370
- US-A- 4 712 609
- SHOTARO NAITO ET AL: "AC DRIVE SYSTEM FOR ELECTRIC VEHICLES" HITACHI REVIEW, vol. 44, no. 3, 1 juin 1995, pages 163-168, XP000550050
- STOCKMEIJER ET AL.: "Reliable 1200 Amp 2500 V IGBT Modules for Traction Applications" IEE COLLOQUIUM ON IGBT PROPULSION DRIVES, 25 avril 1995, LONDON, pages 3/1-3/13, XP002036952

## Description

La présente invention concerne les composants semi-conducteur d'électronique de puissance, en général, et porte, plus particulièrement, sur un dispositif de refroidissement pour composants IGBT.

Un dispositif de refroidissement pour composants IGBT est connu par exemple de l'article de Shotaro Naito et al. "AC Drive system for electric vehicles", Hitachi Review, Vol 44, No 3; Juin 1995; pages 163-168, Tokyo; Japon.

L'utilisation de composant semi-conducteur d'électronique de puissance du type IGBT, en remplacement des thyristors à extinction commandée par la gâchette (GTO), dans des applications de traction ferroviaire sous des tensions élevées, amène à devoir assurer un refroidissement performant.

De plus, les composants du type IGBT de l'état de la technique présentent une isolation interne suffisante pour des applications de tension inférieure à 1500V, mais une isolation supplémentaire est nécessaire au niveau du refroidissement pour certaines applications ferroviaire.

Les montages mécaniques d'un composant type IGBT et d'un thyristor à extinction commandée par la gâchette (GTO) faisant appel à un montage de type "press-pack" sont très différents.

Le thyristor à extinction commandée par la gâchette (GTO) doit être pressé par un effort externe et des connexions électriques sont rapportées sur les deux faces du composant.

Le composant du type IGBT est vissé sur son dispositif de refroidissement, la fonction connexion électrique est intégrée dans le composant et est découplée du montage mécanique et du refroidissement.

Pour des applications nécessitant des performances thermiques faibles, le composant du type IGBT peut être vissé sur un plot bon conducteur de la chaleur, lui-même isolé du milieu extérieur par un produit isolant comme une résine époxyde.

Au niveau des thyristors à extinction commandée par la gâchette (GTO), nécessitant aussi une performance du système de refroidissement élevée et un isolement dans un montage de type "press-pack", diverses techniques ont été utilisées:
- Utilisation d'un bloc de refroidissement traversé par un fluide isolant diélectrique comme de l'huile, ce qui est le cas par exemple dans la chaîne de traction du train à grande vitesse EUROSTAR conçu par la demanderesse.
- Immersion du composant et de son bloc de refroidissement dans un fluide diélectrique, par exemple un fluorocarbone, ce qui est le cas par exemple dans la chaîne de traction des trains à grande vitesse conçus par la demanderesse.
- Utilisation d'une plaque isolante, par exemple en céramique, entre le composant et son refroidisseur.
- Utilisation d'un bloc de refroidissement réalisé dans un bloc en un matériau à la fois bon conducteur de la chaleur et isolant électrique, comme certaines céramiques (Nitrure d'Aluminium), et parcouru par de l'eau. Pour assurer le passage du courant aux bornes du thyristor à extinction commandée par la gâchette (GTO), une connexion électrique est ajoutée entre le bloc de refroidissement et le composant.

Aussi un but de l'invention est-il un dispositif de refroidissement pour composants IGBT, permettant d'assurer un refroidissement performant, en intégrant un isolement entre le composant et le milieu extérieur.

Pour assurer à la fois les performances thermiques et l'isolement du composant, un système de refroidissement performant est nécessaire. Dans ce cas, l'eau avec ses excellentes caractéristiques thermiques, permet d'atteindre les performances requises.

Pour éviter d'avoir à désioniser le liquide, il faut intégrer la fonction isolement entre l'eau et le composant du type IGBT.

L'invention propose donc un dispositif tel que défini dans la revendication 1.

La solution qui consiste à utiliser un dispositif de refroidissement réalisé dans un matériau en céramique isolante bon conducteur de la chaleur présente les meilleurs performances thermiques et diélectrique.

L'interposition d'une plaque isolante entre un refroidisseur métallique et le composant poserait des problèmes de performance thermique avec des contacts thermiques supplémentaire, ou des problèmes technologiques.

Conformément à l'invention, le dispositif de refroidissement pour composants IGBT, se caractérise en ce que ledit composant IGBT est disposé sur un élément de refroidissement en matériau isolant et bon conducteur de la chaleur, ledit élément de refroidissement étant traversé par une circulation d'eau, ledit composant IGBT et ledit élément de refroidissement étant disposés dans une plaque de maintien en matériau isolant.

Le dispositif de refroidissement pour composants IGBT de l'invention satisfait également à l'une au moins des caractéristiques suivantes:
- ledit élément de refroidissement est en céramique isolante,
- ledit élément de refroidissement est en Nitrure d'Aluminium,
- ladite plaque de maintien réalise les connexions hydrauliques dudit élément de refroidissement,
- ledit composant IGBT, ledit élément de refroidissement et ladite plaque de maintien sont maintenus au moyen de vis de fixation.

Un avantage du dispositif de refroidissement pour composants IGBT de l'invention est de pouvoir assembler le nombre voulue de refroidisseurs et de composants du type IGBT sur une seule plaque de façon à réaliser la fonction électrique désirée.

Un autre avantage du dispositif de refroidissement pour composants IGBT de l'invention est que sa conception géométrique permet un bon niveau de tenue diélectrique en limitant la présence de décharge partielle.

D'autres buts, caractéristiques et avantages de l'invention apparaîtront à la lecture de la description du mode de réalisation préféré du dispositif de refroidissement pour composants IGBT, description faite en liaison avec les dessins dans lesquels:
- la figure 1 est une vue générale du dispositif de refroidissement pour composants IGBT conforme à l'invention,
- la figure 2 montre un assemblage d'éléments de refroidissement et de composants du type IGBT selon l'invention.

Le composant 1 du type IGBT est monté sur un élément de refroidissement 2 en matériau isolant et bon conducteur de la chaleur, de préférence en Nitrure d'Aluminium.

Cet élément de refroidissement 2 est traversé par une circulation d'eau 3, selon une géométrie adéquate, assurant l'évacuation des pertes du composant 1 du type IGBT.

L'ensemble est monté, dans une plaque de maintien 4 en matériau isolant, type plastique, permettant le maintien mécanique de l'ensemble et réalisant les connexions hydrauliques 5 de l'élément de refroidissement 2.

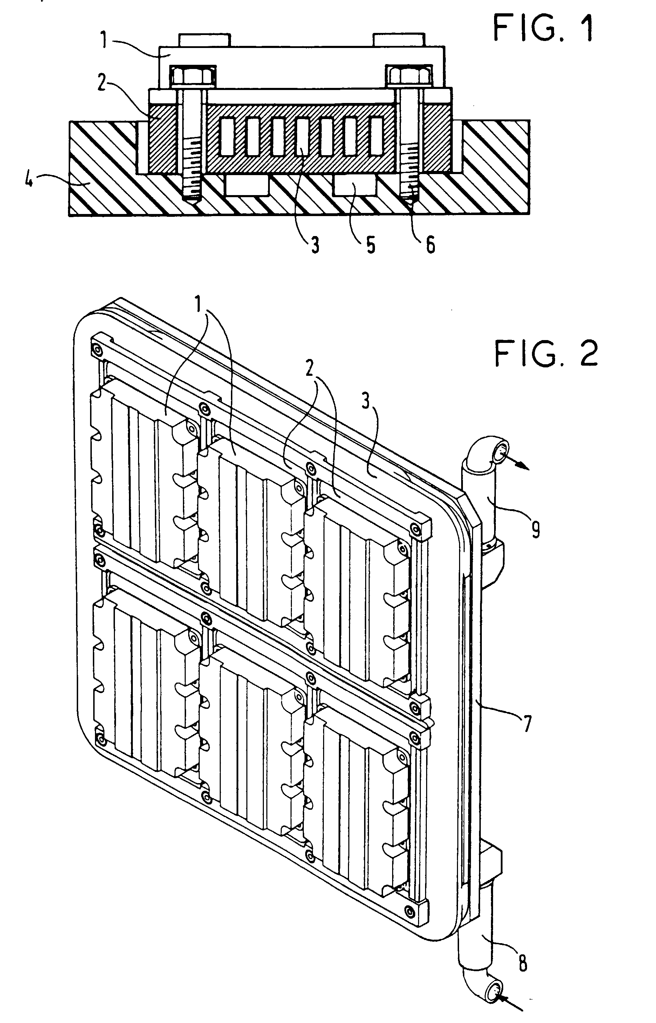

Des moyens de fixation 6, par exemple du type vis, du composant 1 du type IGBT, traversent l'élément de refroidissement 2 et se vissent dans la plaque de maintien 2 de manière à assurer le maintien et le serrage de l'ensemble, comme représenté à la figure 1.

La figure 2 montre qu'il est possible d'assembler le nombre voulue d'éléments de refroidissement 2 et de composants 1 du type IGBT sur une seule plaque de maintien 4 de façon à réaliser la fonction électrique désirée.

L'assemblage d'éléments de refroidissement 2 et de composants 1 du type IGBT sur une seule plaque de maintien 4 est disposé sur une plaque de masse 7 formant la masse, par exemple en aluminium.

La circulation d'eau dans les éléments de refroidissement 2 par l'intermédiaire des connexions hydrauliques disposées dans l'élément de maintien 4 est obtenue au moyen d'un coupleur hydraulique d'entrée 8 de l'eau et d'un coupleur hydraulique 9 de sortie de l'eau.

Un autre avantage du dispositif de refroidissement pour composants IGBT de l'invention réside dans ses performances thermiques.

La résistance thermique de l'ensemble radiateur - eau est inférieure à 10 C/kW, environ 2000 W par composant.

Dans une solution utilisant une plaque isolante, le contact thermique supplémentaire, peut être estimé à 6 C/kW, ce qui donnerait des performances de radiateur de l'ordre de 16 C/kW.

Les solutions de l'état de la technique dans lesquelles le composant est monté sur un plot bon conducteur de la chaleur, puis reportant l'isolement, par exemple avec une résine époxide, entre le plot et un radiateur à ailette ne permettent pas d'évacuer plus de quelques centaines de watts.

Un autre avantage du dispositif de refroidissement pour composants IGBT de l'invention réside dans l'isolement.

Au niveau de l'isolement, l'utilisation d'une pièce massive en matériaux isolant élimine les interfaces, zone à risque sur le plan des décharges partielles.

Un autre avantage du dispositif de refroidissement pour composants IGBT de l'invention réside dans l'encombrement.

L'encombrement du dispositif de la solution est réduit par rapport à des solutions de l'état de la technique intégrant une plaque intercalaire isolante, nécessitant une distance supplémentaire pour les lignes de fuites, à savoir: un débordement de la plaque d'une vingtaine de millimètres du composant.

De plus, le passage de la vis à travers la plaque intercalaire isolante de la solution de l'état de la technique pose un problème difficile à résoudre.

## Revendications

1. Dispositif de refroidissement pour composants (1) IGBT, ledit composant IGBT étant disposé sur un élément de refroidissement (2) en matériau bon conducteur de la chaleur, ledit élément de refroidissement (2) étant traversé par une circulation d'eau (3), caractérisé en ce que ledit élément de refroidissement (2) est réalisé en matériau électriquement isolant, et en ce que ledit composant (1) IGBT et ledit élément de refroidissement (2) sont disposés dans une plaque de maintien (4) en matériau électriquement isolant.

2. Dispositif selon la revendication 1, dans lequel ledit élément de refroidissement (2) est en céramique électriquement isolante.

3. Dispositif selon la revendication 2, dans lequel ledit élément de refroidissement (2) est en Nitrure d'Aluminium.

4. Dispositif selon l'une quelconque des revendications 1 à 3, dans lequel ladite plaque de maintien (4) réalise les connexions hydrauliques (5) dudit élément de refroidissement (2).

5. Dispositif selon l'une quelconque des revendications 1 à 4, dans lequel ledit composant (1) IGBT, ledit élément de refroidissement (2) et ladite plaque de maintien (4) sont maintenus au moyen de moyens de fixation (6) .

## Patentansprüche

1. Kühlvorrichtung für IGBT-Bauelemente (1), wobei das IGBT-Bauelement auf einem Kühlelement (2) aus gut wärmeleitendem Material angeordnet ist, wobei das Kühlelement (2) von einem Wasserumlauf (3) durchflossen wird, dadurch gekennzeichnet, daß das Kühlelement (2) aus elektrisch isolierendem Material ausgeführt ist und daß das IGBT-Bauelement (1) und das Kühlelement (2) in einer Halteplatte (4) aus elektrisch isolierendem Material angeordnet sind.

2. Vorrichtung nach Anspruch 1, bei welcher das Kühlelement (2) aus elektrisch isolierender Keramik besteht.

3. Vorrichtung nach Anspruch 2, bei welcher das Kühlelement (2) aus Aluminiumnitrid besteht.

4. Vorrichtung nach einem der Ansprüche 1 bis 3, bei welcher die Halteplatte (4) die hydraulischen Verbindungen (5) für das Kühlelement (2) herstellt.

5. Vorrichtung nach einem der Ansprüche 1 bis 4, bei welcher das IGBT-Bauelement (1), das Kühlelement (2) und die Halteplatte (4) mittels Befestigungsmitteln (6) gehalten werden.

## Claims

1. A cooler device for IGBT components (1), said IGBT component being disposed on a cooler element (2) of a material that is a good conductor of heat, said cooler element (2) having water circulation (3) passing therethrough, the device being characterized in that said cooler element (2) is made of an electrically insulating material, and in that said IGBT component (1) and said cooler element (2) are placed in a support plate (4) of electrically insulating material.

2. A device according to claim 1, in which said cooler element (2) is made of an electrically insulating ceramic.

3. A device according to claim 2, in which said cooler element (2) is made of aluminum nitride.

4. A device according to any one of claims 1 to 3, in which said support plate (4) provides the hydraulic connections (5) of said cooler element (2).

5. A device according to any one of claims 1 to 4, in which said IGBT component (1), said cooler element (2), and said support plate (4) are held together by fixing means (6).
